# EUROPEAN PATENT APPLICATION

(11) **EP 4 814 514 A1**
(43) Date of publication of application: **30.09.2026**
(21) Application number: 24915423.8
(22) Date of filing: 26.12.2024
(51) Int. Cl.: G01R 31/40, G01R 31/34, G01R 31/327, G01R 31/52, H02P 27/06, H02M 7/537

(54) **ELECTRONIC DEVICE AND CONTROL METHOD THEREFOR**

(30) Priority: 03.01.2024 KR 20240000795
(71) Applicant: Samsung Electronics Co., Ltd., Suwon-si, Gyeonggi-do 16677 (KR)
(72) Inventor: LEE, Seunghun, Suwon-si Gyeonggi-do 16677 (KR); PARK, Junhyun, Suwon-si Gyeonggi-do 16677 (KR); LEE, Sungmo, Suwon-si Gyeonggi-do 16677 (KR)
(74) Representative: Walaski, Jan Filip
(86) International application number: PCT/KR2024/021154
(87) International publication number: WO 2025/147011

(57) **Abstract**

An electronic apparatus is disclosed. The electronic apparatus includes an inverter including a plurality of switch pairs each including first and second switches connected in series, a three-phase motor respectively connected to connection nodes between the first and second switches in the plurality of switch pairs, and a processor configured to control the inverter to convert direct current (DC) power into three-phase alternating current (AC) power and provide the three-phase alternating current power to the three-phase motor. The processor is configured to control each second switch included in the plurality of switch pairs to be in the on state for a preset second time, and identify whether each first switch is abnormal based on a magnitude of a current detected in the inverter during the second time.

## Description

### [Technical Field]

The present disclosure relates to an electronic apparatus and a controlling method thereof.

### [Background Art]

In electronic apparatuses such as a washing machine, an air conditioner, and a refrigerator, an inverter for converting direct current (DC) power into alternating current (AC) power may be used. In addition, as miniaturization of electronic apparatuses increases, application of Intelligent Power Modules (IPMs) within an inverter is also increasing. An IPM includes various protection circuits such as an overcurrent protection circuit and a short-circuit protection circuit therein.

However, when a short current is generated due to repetitive arm short during use of the inverter, damage may occur to the IPM due to a thermal runaway phenomenon, and the IPM may be destroyed, thereby causing a fire. Here, the arm short refers to a state in which switches connected in series in the inverter are all closed, thereby generating a short current.

### [Disclosure]

### [Technical Solution]

An electronic apparatus according to at least one embodiment includes an inverter including a plurality of switch pairs each including first and second switches connected in series, a three-phase motor respectively connected to connection nodes between the first and second switches in the plurality of switch pairs, and a processor configured to control the inverter to convert direct current (DC) power into three-phase alternating current (AC) power and provide the three-phase alternating current power to the three-phase motor.

The processor controls each first switch included in the plurality of switch pairs to be in an on state for a preset first time, and identifies whether each second switch included in the plurality of switch pairs is abnormal based on a magnitude of a current detected in the inverter during the first time. The processor controls each second switch included in the plurality of switch pairs to be in the on state for a preset second time, and identifies whether each first switch is abnormal based on a magnitude of a current detected in the inverter during the second time.

Meanwhile, a method of controlling an electronic apparatus including n inverter including a plurality of switch pairs each including first and second switches connected in series and a three-phase motor according to one or more embodiments include turning on each first switch included in the plurality of switch pairs for a preset first time, identifying whether each second switch included in the plurality of switch pairs is abnormal based on a magnitude of a current detected in the inverter during the first time, turning on each second switch included in the plurality of switch pairs for a preset second time, and identifying whether each first switch is abnormal based on a magnitude of a current detected in the inverter during the second time.

Meanwhile, in a computer-readable recording medium including a program for executing a method of controlling an electronic apparatus according to one or more embodiments, the controlling method includes turning on each first switch included in the plurality of switch pairs for a preset first time, identifying whether each second switch included in the plurality of switch pairs is abnormal based on a magnitude of a current detected in the inverter during the first time, turning on each second switch included in the plurality of switch pairs for a preset second time, and identifying whether each first switch is abnormal based on a magnitude of a current detected in the inverter during the second time.

### [Description of Drawings]

FIG. 1 is a block diagram illustrating configuration of an electronic apparatus according to various embodiments;
FIG. 2 is a block diagram illustrating detailed configuration of an electronic apparatus according to various embodiments;
FIG. 3 is a circuit diagram illustrating detailed configuration of an electronic apparatus according to various embodiments;
FIGS. 4 and 5 are views provided to explain an operation of an inverter according to various embodiments; and
FIGS. 6 and 7 are flowcharts provided to explain a method of controlling an electronic apparatus according to various embodiments.

### [Mode for Invention]

Hereinafter, the present disclosure will be described in detail with reference to the accompanying drawings.

Various embodiments in this disclosure and the terms used herein do not intend to limit the technical features in this disclosure to specific embodiments, but should be understood to include various modifications, equivalents or alternatives of the corresponding embodiments.

With respect to the description of the drawings, similar components may be denoted by similar reference numerals.

The singular form of a noun corresponding to an item may include one item or a plurality of items, unless the relevant context clearly indicates otherwise.

In this disclosure, "A or B", "at least one of A and B", "at least one of A or B", "A, B or C", "at least one of A, B and C", and "at least one of A, B, or C" may each include any one of the items listed together in the corresponding phrase, or any possible combination thereof.

The term "and/or" includes a combination of a plurality of related elements described herein or any element of a plurality of related elements described herein.

The terms "first", "second", "1^{st}," or "2^{nd}," may be used simply to distinguish the corresponding component from other corresponding components, and may limit the corresponding components in other aspects (e.g. : importance or order).

When it is mentioned that one (e.g., first) component is "coupled" or "connected" to another (e.g., second) component, with or without the terms "functionally" or "communicatively", it means that the component can be connected to another component directly (e.g. wired), wirelessly, or through a third component.

Terms such as "have" or "include" are intended to designate the presence of features, numbers, steps, operations, components, parts, or a combination thereof described in this disclosure, but are not intended to exclude the presence or addition of one or more other features, numbers, steps, operations, components, parts, or a combination thereof in advance.

When a component is said to be "connected," "coupled," "supported," or "in contact" with another component, this means not only when the components are directly connected, coupled, supported, or in contact, but also when they are indirectly connected, coupled, supported, or in contact through a third component.

When a component is said to be located "on" another component, this includes not only a case where a component is in contact with another component, but also a case where another component exists between the two components.

Hereinafter, an embodiment of the present disclosure will be described in greater detail with reference to the accompanying drawings.

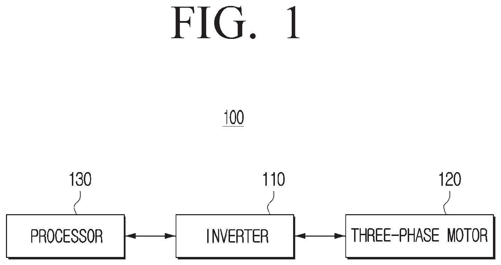

FIG. 1 is a block diagram illustrating configuration of an electronic apparatus according to various embodiments.

An electronic apparatus 100 may be implemented as a washing machine, a dryer, an air conditioner, a blower, an air purifier, a ventilator, an electric fan, a dehumidifier, a vacuum cleaner, or the like that uses a three-phase motor.

Among these, the washing machine performs an operation for removing contaminants adhered to laundry.

As an example, the washing machine may be implemented as a front-loading washing machine using a drum. In the case of a front-loading washing machine, laundry may be washed by rotating the drum to repeatedly lift and drop the laundry. In order to rotate the drum, the washing machine may use a three-phase motor. Driving force generated by the three-phase motor may be transmitted to the drum through a rotating shaft, thereby rotating the drum in a forward direction or a reverse direction.

Referring to FIG. 1, the electronic apparatus 100 includes an inverter 110, a three-phase motor 120, and a processor 130.

The inverter 110 includes a plurality of switch pairs each including first and second switches. Specifically, the inverter 110 is configured with a plurality of switching pairs in which the first switch and the second switch are connected in series, and the respective switching pairs are connected in parallel. The inverter 110 may convert direct current (DC) power into alternating current (AC) power. Detailed operation of the inverter 110 will be described later.

The three-phase motor 120 is respectively connected to connection nodes between the first and second switches in the plurality of switch pairs. The three-phase motor 120 operates by AC power and may provide rotational force to the electronic apparatus 100.

As an example, when the electronic apparatus 100 of FIG. 1 is implemented as a washing machine, the three-phase motor 120 may provide rotational force for rotating the drum. The three-phase motor 120 of the washing machine may rotate the drum in a forward or reverse direction to perform respective operations corresponding to washing, rinsing, spin-drying, or drying cycles.

The processor 130 is configured to be connected to respective components of the electronic apparatus 100 and to generally control operations of the electronic apparatus 100. The processor 130 may be implemented as a digital signal processor (DSP), a microprocessor, a Graphics Processing Unit (GPU), an Artificial Intelligence (AI) processor, or a Neural Processing Unit (NPU). However, the processor 130 is not limited thereto, and may include one or more of a Central Processing Unit (CPU), a Micro Controller Unit (MCU), a Micro Processing Unit (MPU), a controller, an Application Processor (AP), a Communication Processor (CP), or an ARM processor, or may be defined by such terms. In addition, the processor 130 may be implemented as a System on Chip (SoC) or a Large Scale Integration (LSI) device in which a processing algorithm is embedded, or may be implemented in the form of an Application Specific Integrated Circuit (ASIC) or a Field Programmable Gate Array (FPGA).

The processor 130 controls the inverter 110 to convert DC power into three-phase AC power and provide the three-phase AC power to the three-phase motor 120. The processor 130 controls each first switch included in the plurality of switch pairs to be in an on state for a preset first time, and identifies whether each second switch included in the plurality of switch pairs is abnormal based on a magnitude of a current detected in the inverter 110 during the first time. In this case, the processor 130 may control each second switch included in the plurality of switch pairs to be in an off state during the first time.

If at least one of the second switches is damaged, a first switch connected in series with the damaged second switch may enter an arm short state, thereby generating a short-circuit current. The processor 130 may identify whether the second switch is abnormal by comparing a preset first reference current value with the magnitude of the detected current. For example, when the magnitude of the detected current is equal to or greater than the first reference current value, the processor 130 may determine that the second switch is abnormal.

The processor 130 controls each second switch included in the plurality of switch pairs to be in an on state for a preset second time, and identifies whether each first switch is abnormal based on a magnitude of a current detected in the inverter 110 during the second time. In this case, the processor 130 may control each first switch included in the plurality of switch pairs to be in an off state during the second time.

If at least one of the first switches is damaged, a second switch connected in series with the damaged first switch may enter an arm short state, thereby generating a short-circuit current. The processor 130 may identify whether the first switch is abnormal by comparing a preset second reference current value with the magnitude of the detected current. For example, when the magnitude of the detected current is equal to or greater than the second reference current value, the processor 130 may determine that the first switch is abnormal.

The first reference current value and the second reference current value may be set to be identical. Alternatively, when the first switch and the second switch are implemented as different elements, the first reference current value and the second reference current value may be set to different values. Hereinafter, for convenience of description, it is assumed that the first reference current value and the second reference current value are identical, and the first reference current value and the second reference current value will be described as a reference current value.

The first time and the second time may each be set to a time equal to or greater than a minimum pulse width capable of detecting a short-circuit current in the inverter 110. For example, when a minimum Pulse Width Modulation (PWM) pulse width applied to the inverter 110 for detecting a short-circuit current generated when the first switch or the second switch is damaged is 1 µs, the first time and the second time may be set to 1 µs or greater. However, when actually applying the first time and the second time to the inverter 110 to turn the first and second switches on/off, the processor 130 may add a margin time to the minimum PWM pulse width in order to accurately detect the short-circuit current, and may set the first time and the second time accordingly.

The first time and the second time may be set to be identical, or may be set to be different according to operation of the three-phase motor 120. For example, when the processor 130 identifies whether the second switch is abnormal by using a bootstrap operation time of the three-phase motor 120, the processor 130 may set the first time as the bootstrap operation time of the three-phase motor 120 and control each first switch included in the plurality of switch pairs to be in the on state during the first time in which bootstrapping of the three-phase motor 120 is performed. In this case, the processor 130 may identify whether each second switch included in the plurality of switch pairs is abnormal based on a magnitude of a current detected in the inverter 110 during the first time corresponding to the bootstrap time (for example, 50 ms).

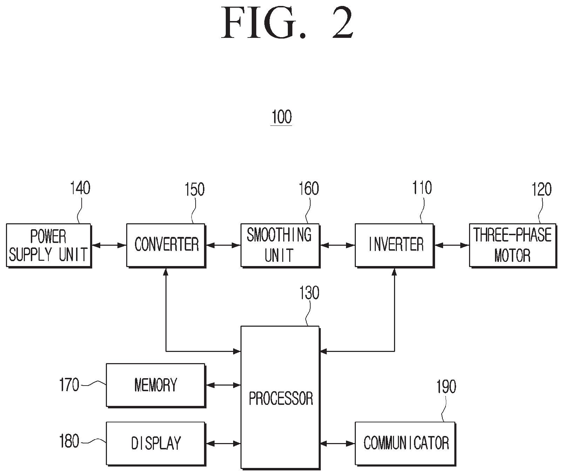

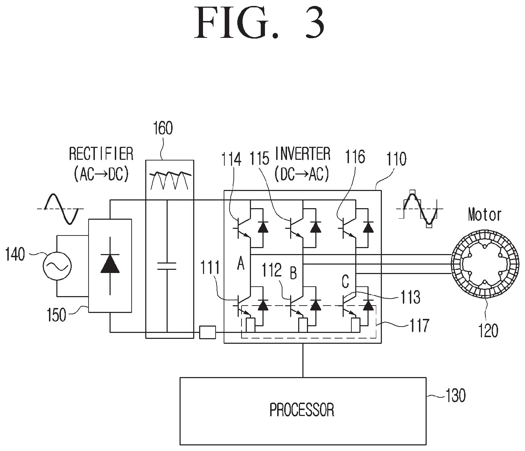

FIG. 2 is a block diagram illustrating detailed configuration of an electronic apparatus according to various embodiments, and FIG. 3 is a circuit diagram illustrating detailed configuration of an electronic apparatus according to various embodiments.

According to FIGS. 2 and 3, the electronic apparatus 100 may include a power supply unit 140, a converter 150, a smoothing unit 160, an inverter 110, a three-phase motor 120, a processor 130, memory 170, a display 180, and a communicator 190. Among the configurations illustrated in FIGS. 2 and 3, detailed descriptions of configurations overlapping with those illustrated in FIG. 1 will be omitted.

The power supply unit 140 is configured to provide AC power to the electronic apparatus 100. The power supply unit 140 may provide commercial AC power supplied from an external source to the electronic apparatus 100.

The converter 150 is configured to convert AC power provided from the power supply unit 140 into DC power. The converter 150 may include a rectifier that rectifies AC power into DC power under the control of the processor 130. For example, the converter 150 may include at least one diode.

The smoothing unit 160 is configured to reduce ripple of the DC power converted by the converter 150. The smoothing unit 160 may include at least one capacitor. The smoothing unit 160 may step up or step down the DC voltage rectified by the converter 150 under the control of the processor 130, or may control a power factor. For example, the smoothing unit 160 may reduce ripple of the DC power converted by the converter 150 to implement a smoothed DC power, and may convert the DC power into DC power of a preset magnitude for driving the three-phase motor 120 and provide the converted DC power to the inverter 110.

The inverter 110 may convert the DC power provided from the smoothing unit 160 into three-phase U, V, and W AC power and provide the converted power to the three-phase motor 120. The inverter 110 may include an Intelligent Power Module (IPM) for converting DC power into three-phase AC power U, V, and W based on a Pulse Width Modulation signal (PWM).

The IPM refers to a module in which devices such as Insulated Gate Bipolar Transistor (IGBT) or MOSFET, a driving circuit, and a protection circuit are integrated. For example, the IPM may be implemented with six IGBTs and a three-phase gate driver. Referring to FIG. 3, when the IPM includes six IGBTs, IGBTs corresponding to first switches 111, 112, and 113 and IGBTs corresponding to second switches 114, 115, and 116 may be connected in series to implement three switch pairs.

The IPM includes various protection circuits such as an overcurrent protection circuit and a short-circuit protection circuit, thereby facilitating design, reducing power consumption, and enabling miniaturization of the apparatus. In particular, since the IPM has a larger allowable current capacity per unit area than conventional switching power devices, the IPM may be used for power management solutions in the field of controlling high-capacity motors.

According to FIG. 3, the inverter 110 may include the IPM including first switches 111, 112, and 113 and second switches 114, 115, and 116, and may further include a sensing unit 117 connected to the first switches 111, 112, and 113 or the second switches 114, 115, and 116 to detect current. In FIG. 3, the three first switches 111, 112, and 113 are connected to a negative node of DC power, and the three second switches 114, 115, and 116 are connected to a positive node of the DC power.

Further, the three first switches 111, 112, and 113 and the three second switches 114, 115, and 116 are connected in series to configure three switch pairs, and the three switch pairs are connected in parallel. Specifically, the first switch 111 and the second switch 114, the first switch 112 and the second switch 115, and the first switch 113 and the second switch 116 are respectively connected in series to configure three switch pairs. In this case, the first switches 111, 112, and 113 and the second switches 114, 115, and 116 in the IPM may be implemented as IGBTs.

The IGBT refers to a transistor implemented to have advantages of both a Metal Oxide Semiconductor (MOSFET) and a bipolar transistor. The IGBT is a composite device in which an input portion is implemented in a MOSFET structure and an output portion has a bipolar transistor structure. The IGBT has advantages of a MOSFET having high input impedance and fast switching speed and advantages of a bipolar transistor having low on-resistance even at high withstand voltage.

However, the present disclosure is not limited thereto, and the first switches 111, 112, and 113 and the second switches 114, 115, and 116 may be implemented as at least one of a Gate Turn-Off Thyristor (GTO), a Metal Oxide Semiconductor Field Effect Transistor (MOSFET), a Bipolar Junction Transistor (BJT), a Silicon Controlled Rectifier (SCR), a Triode for Alternating Current (TRIAC), a Unijunction Transistor (UJT), a Programmable Unijunction Transistor (PUT), a Junction Field Effect Transistor (JFET), a MOS Controlled Thyristor (MCT), an Injection-Enhanced Gate Transistor (IEGT), or an Integrated Gate Commutated Thyristor (IGCT).

Here, the GTO refers to a device developed to improve a turn-off function of a conventional thyristor device. A conventional thyristor device may be turned on by applying current to a gate, but in order to turn off the device, the circuit itself must be mechanically interrupted. However, the GTO may turn off the switch by applying reverse current to the gate using an electrical method.

In FIG. 3, the sensing unit 117 may include at least one sensor connected to the first switches 111, 112, and 113 or the second switches 114, 115, and 116 to detect current. The sensing unit 117 may further include at least one sensing resistor connected to the first switches 111, 112, and 113 or the second switches 114, 115, and 116. The sensing unit 117 may detect current at each node to which the sensing resistor is connected by using the sensing resistor. In this case, the sensing resistor may be implemented as a shunt resistor.

A shunt resistor refers to a low-resistance resistor mainly used to measure current. When the shunt resistor is connected in series in the middle of a wire through which current flows, the processor 130 may calculate a current value based on a magnitude of voltage generated across the shunt resistor.

The processor 130 may control operations of the electronic apparatus 100. For example, the processor 130 may control operations of the converter 150, the smoothing unit 160, the inverter 110, the memory 170, the display 180, and the communicator 190. The processor 130 may control on and off states of respective switches in the inverter 110 using a PWM signal.

The processor 130 may perform control operations related to the PWM signal. The processor 130 may generate the PWM signal, and may vary a pulse width of the generated PWM signal. The processor 130 may control on and off times of the first switches 111, 112, and 113 and the second switches 114, 115, and 116 according to the pulse width of the varied PWM signal. Although a case in which the processor 130 generates the PWM signal has been described, when the electronic apparatus 100 separately includes a PWM generating device for generating the PWM signal, the processor 130 may perform the operation of controlling the PWM generating device.

When a signal for operating the three-phase motor 120 is input, the processor 130 may identify whether each switch in the inverter 110 is abnormal before starting the three-phase motor 120. Specifically, before starting the three-phase motor 120, the processor 130 may control each second switch 114, 115, and 116 included in the plurality of switch pairs to be in an on state for a preset second time, and may identify whether each first switch 111, 112, and 113 is abnormal based on a magnitude of current detected in the inverter 110 during the second time.

Further, when a current value detected in at least one of the first and second switches 111, 112, 113, 114, 115, or 116 in the inverter 110 is equal to or greater than a preset reference current value, the processor 130 may control the first and second switches 111, 112, 113, 114, 115, and 116 in the inverter 110 to be in an off state to stop operation of the three-phase motor 120. When the detected current value is within the preset reference current value, the processor 130 may operate the three-phase motor 120.

The memory 170 may store at least one instruction, data, or program necessary for operation of the electronic apparatus 100. For example, the memory 170 may store data regarding a first time and a second time. The processor 130 may set the first time and the second time to be equal to or greater than a minimum pulse width capable of detecting a short current in the inverter 110 and may store the first time and the second time in the memory 170.

The memory 170 may be implemented as embedded memory in the electronic apparatus 100 or as detachable memory attachable to and detachable from the electronic apparatus 100 according to a data storage purpose. For example, data for driving the electronic apparatus 100 may be stored in embedded memory, and data for extended functions of the electronic apparatus 100 may be stored in detachable memory.

In the case of memory embedded in the electronic apparatus 100, the memory may be implemented as at least one of a volatile memory (e.g., Dynamic Random Access Memory (DRAM), Static Random Access Memory (SRAM), or Synchronous Dynamic Random Access Memory (SDRAM)), or a non-volatile memory (e.g., One Time Programmable Read Only Memory (OTPROM), Programmable Read Only Memory (PROM), Erasable and Programmable Read Only Memory (EPROM), Electrically Erasable and Programmable Read Only Memory (EEPROM), Mask Read Only Memory (Mask ROM), Flash Read Only Memory (Flash ROM), flash memory (e.g., NAND flash or NOR flash), a hard drive, or a Solid State Drive (SSD)).

The memory 170 may be implemented as a single memory storing data generated in various operations according to the present disclosure, but is not limited thereto, and may include a plurality of memories storing different types of data or data generated at different stages.

The memory 170 may store information on the first time, the second time, and the above-described reference current value.

The display 180 may perform display operations under control of the processor 130. For example, when a current value detected in at least one of the first switches 111, 112, and 113 and the second switches 114, 115, or 116 in the inverter 110 is equal to or greater than the preset reference current value, the processor 130 may control the display 180 to display a fault state.

The display 180 may be implemented as a display including a self-emissive device or as a display including a non-self-emissive device and a backlight. For example, the display 180 may be implemented as various types of displays, such as a Liquid Crystal Display (LCD), an Organic Light Emitting Diode (OLED) display, a Light Emitting Diode (LED) display, a micro Light Emitting Diode (micro LED) display, a Mini Light Emitting Diode (Mini LED) display, a Plasma Display Panel (PDP), a Quantum Dot (QD) display, and a Quantum Dot Light-Emitting Diode (QLED) display..

The communicator 190 is configured to perform communication with a user terminal apparatus. When a current value detected in at least one of the first and second switches 111, 112, 113, 114, 115, or 116 is equal to or greater than the preset reference current value, the processor 130 may control the communicator 190 to transmit an error signal to a preset user terminal apparatus.

The communicator 190 may include at least one of a short-range communication module or a long-range communication module. The communicator 190 may transmit data to an external apparatus (e.g., a user terminal apparatus, a server, a user device, and/or a home appliance), or may receive data from the external apparatus.

Although FIGS. 1 to 3 have been described based on a case in which at least one sensor for detecting current is included in the inverter 110, when the electronic apparatus 100 does not include a sensor for detecting current in the inverter 110, the electronic apparatus 100 may further include a sensing module (not shown) connected to the first switches 111, 112, and 113 or the second switches 114, 115, and 116 to detect current. The sensing module may operate under control of the processor 130 to detect current flowing through the serially connected first switches 111, 112, and 113 and second switches 114, 115, and 116.

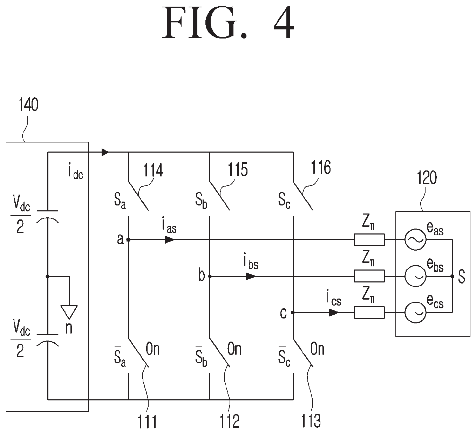

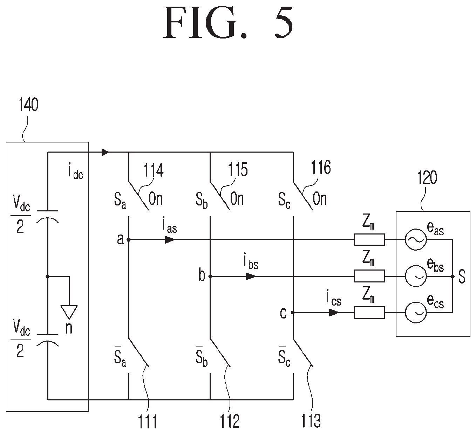

FIGS. 4 and 5 are views provided to explain an operation of an inverter according to various embodiments. FIG. 4 is a view illustrating an operation of the inverter 110 for detecting whether the first switches are abnormal.

Referring to FIG. 4, one end of each of the first switches 111, 112, and 113 is connected to a negative node of DC power, and the other end of each of the first switches 111, 112, and 113 is respectively connected in series to second switches 114, 115, and 116. In FIG. 4, the inverter 110 includes three switch pairs in which the first switches 111, 112, and 113 and the second switches 114, 115, and 116 are connected in series, and the three switch pairs are connected in parallel. Further, three phases of the three-phase motor 120 are respectively connected to connection nodes a, b, and c between each of the first and second switches 111, 112, 113, 114, 115, and 116.

The processor 130 may control the first switches 111, 112, and 113 to be in an on state for a preset first time. In this case, the processor 130 may set the first time as a bootstrap time of the three-phase motor 120.

When starting the three-phase motor 120, the electronic apparatus 100 may charge the first switches 111, 112, and 113 through a bootstrap operation and then start the motor 120. Accordingly, when the first time is set as a bootstrap operation time, sufficient time may be secured during the bootstrap operation before starting the motor 120 to identify whether the second switches 114, 115, and 116 are abnormal. However, this time is merely set to utilize the bootstrap time during operation of the three-phase motor 120 and is not limited thereto, and the first time may be any time period as long as a sensor of the inverter 110 can detect a short current. For example, when a minimum PWM pulse width applied to the inverter 110 for detecting a short current by the sensor is 1 µs, the processor 130 may set the first time to 2 µs.

The processor 130 may control the first switches 111, 112, and 113 to be in the on state using a PWM signal. For example, when the first switches 111, 112, and 113 and the second switches 114, 115, and 116 are implemented as N-channel type IGBTs, the processor 130 may apply a high pulse to the first switches 111, 112, and 113 during the first time to control the first switches 111, 112, and 113 to be in the on state. In this case, the processor 130 may apply a low pulse to the second switches 114, 115, and 116 to control the second switches 114, 115, and 116 to be in an off state.

If at least one of the second switches 114, 115, or 116 is damaged, an arm short may occur through the first switches 111, 112, and 113 in an on state that are connected in series with the damaged second switches 114, 115, and 116. When the arm short state occurs, since a short current is generated, the processor 130 may identify whether the second switches 114, 115, and 116 are abnormal based on a sensing result of the sensing unit 117. Here, the arm short indicates that all of the switches connected in series within the inverter 110 are in a closed state, thereby generating the short current.

FIG. 5 is a view illustrating an operation of the inverter 110 for detecting whether the second switches 114, 115, and 116 are abnormal. Since configurations and connection relationships of the first switches 111, 112, and 113 and the second switches 114, 115, and 116 in the inverter 110 have been described in detail with reference to FIG. 4, repeated descriptions will be omitted.

Referring to FIG. 5, the processor 130 may control the second switches 114, 115, and 116 to be in the on state for a preset second time. The processor 130 may control the second switches 114, 115, and 116 to be in the on state using a PWM signal. For example, when the first switches 111, 112, and 113 and the second switches 114, 115, and 116 are implemented as N-channel type IGBTs, the processor 130 may apply a high pulse to the second switches 114, 115, and 116 during the second time to control the second switches 114, 115, and 116 to be in the on state. In this case, the processor 130 may apply a low pulse to the first switches 111, 112, and 113 to control the first switches 111, 112, and 113 to be in the off state.

If at least one of the first switches 111, 112, and 113 is damaged, an arm short may occur through the second switches 114, 115, and 116 in an on state that are connected in series with the damaged first switches 111, 112, and 113. When the arm short state occurs, since a short current is generated, the processor 130 may identify whether the first switches 111, 112, and 113 are abnormal based on a sensing result of the sensing unit 117.

Meanwhile, after performing a bootstrap operation in which the first switches 111, 112, and 113 are controlled to be in the on state to charge the second switches 114, 115, and 116, the electronic apparatus 100 may start the three-phase motor 120. In an initial stage of starting the three-phase motor 120, a signal having a relatively short pulse width is applied, and as the speed increases, the applied pulse width increases. Accordingly, when a short pulse signal having a pulse width equal to or less than a reference pulse width that cannot be detected by the sensing unit 117 is applied at the initial stage of starting the motor 120, even if at least one of the first switches 111, 112, or 113 in the inverter 110 is damaged, the processor 130 cannot identify whether the switch is abnormal.

When repetitive arm shorts occur due to damage of a switch in the inverter 110 and a short current is generated as a result thereof, a problem may occur in which the inverter 110 is damaged or destroyed due to thermal runaway, and a fire may occur.

However, according to various embodiments of the present disclosure, the electronic apparatus 100 may identify whether the first switches 111, 112, and 113 and the second switches 114, 115, and 116 are abnormal before starting the three-phase motor 120, thereby preventing damage to the electronic apparatus 100 and preventing a fire caused by damage of the inverter 110.

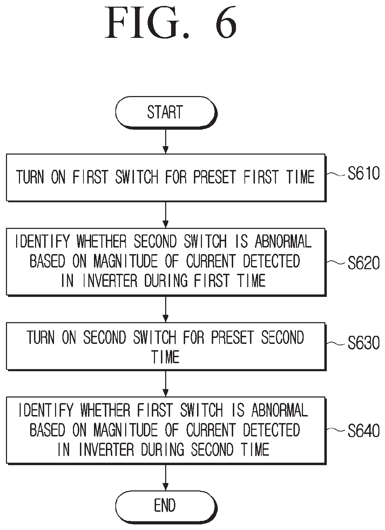

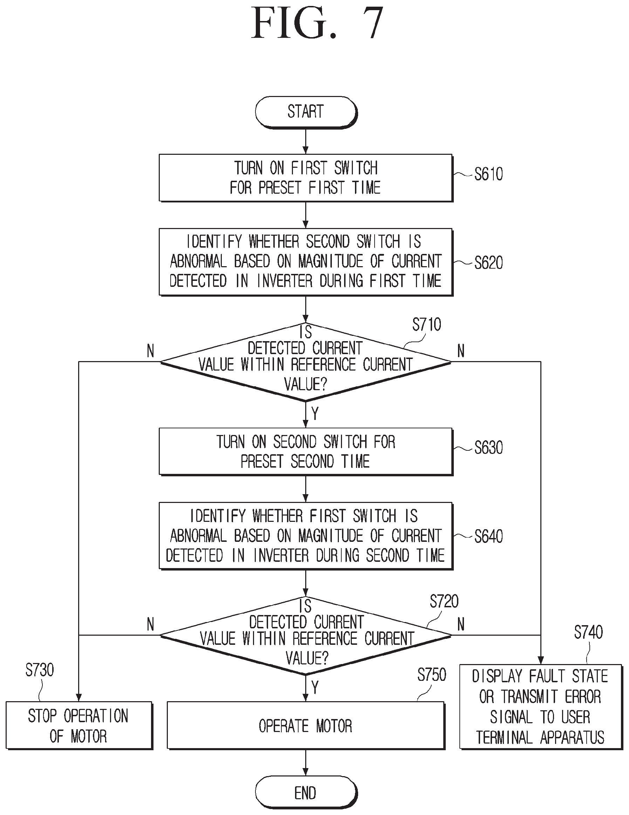

FIGS. 6 and 7 are flowcharts provided to explain a method of controlling an electronic apparatus according to various embodiments.

According to one or more embodiments, the electronic apparatus may include an inverter including a plurality of switch pairs each including a first switch and a second switch connected in series, and a three-phase motor.

Referring to FIG. 6, the electronic apparatus turns on each first switch included in the plurality of switch pairs for a preset first time (S610). In this case, the electronic apparatus turns off each second switch included in the plurality of switch pairs during the first time. The electronic apparatus may set and store the first time as a bootstrap time of the three-phase motor.

However, the present disclosure is not limited thereto, and the first time may be any time period as long as a short current can be detected by a sensor of the electronic apparatus. For example, the electronic apparatus may set and store the first time as a time period equal to or greater than a minimum pulse width capable of detecting a short current in the inverter.

The electronic apparatus identifies whether each second switch included in the plurality of switch pairs is abnormal based on a magnitude of current detected in the inverter during the first time (S620).

In this case, if at least one of the second switches is damaged, a first switch connected in series with the damaged second switch may enter an arm short state, thereby generating a short current. Accordingly, the electronic apparatus may detect the short current, and identify whether the second switch is abnormal based on the detected short current.

The electronic apparatus turns on each second switch included in the plurality of switch pairs for a preset second time (S630). In this case, the electronic apparatus turns off each first switch included in the plurality of switch pairs during the second time. The electronic apparatus may set and store the second time as a time period equal to or greater than a minimum pulse width capable of detecting a short current in the inverter.

The electronic apparatus identifies whether each first switch is abnormal based on a magnitude of current detected in the inverter during the second time (S640).

In this case, if at least one of the first switches is damaged, a second switch connected in series with the damaged first switch may enter an arm short state, thereby generating a short current. Accordingly, the electronic apparatus may detect the short current, and identify whether the first switch is abnormal based on the detected short current.

FIG. 7 is a flowchart illustrating a method of controlling an electronic apparatus in detail according to various embodiments.

Referring to FIG. 7, the electronic apparatus turns on each first switch included in the plurality of switch pairs for a preset first time (S610), and may identify whether each second switch included in the plurality of switch pairs is abnormal based on a magnitude of current detected in the inverter during the first time (S620).

The electronic apparatus may determine whether a detected current value is within a reference current value based on a result of identifying whether the second switch is abnormal (S710). When the detected current value is within the reference current value based on the determination result, the electronic apparatus may perform a next step (S630). For example, when current values detected at the first and second switches are within the reference current value, the electronic apparatus may turn on each second switch included in the plurality of switch pairs for a preset second time (S630).

In this case, when a current value detected from at least one of the first or second switches is equal to or greater than the reference current value, the electronic apparatus may turn off the first and second switches to stop operation of the three-phase motor (S730). Alternatively, when a current value detected from at least one of the first or second switches is equal to or greater than the reference current value, the electronic apparatus may display a fault state (S740). Further, when a current value detected from at least one of the first or second switches is equal to or greater than the reference current value, the electronic apparatus may transmit an error signal to a user terminal apparatus that performs communication with the electronic apparatus (S740).

The electronic apparatus turns on each second switch included in the plurality of switch pairs for a preset second time (S630), and may identify whether each first switch is abnormal based on a magnitude of current detected in the inverter during the second time (S640).

The electronic apparatus may determine whether a detected current value is within the reference current value based on a result of identifying whether the first switch is abnormal (S720). When the detected current value is within the reference current value based on the determination result, the electronic apparatus may perform a next step (S750). For example, when current values detected at the first and second switches are within the reference current value, the electronic apparatus may control the first and second switches to operate the three-phase motor.

In this case, when a current value detected from at least one of the first or second switches is equal to or greater than the reference current value, the electronic apparatus may turn off the first and second switches to stop operation of the three-phase motor (S730). Alternatively, when a current value detected from at least one of the first or second switches is equal to or greater than the reference current value, the electronic apparatus may display a fault state (S740). Further, when a current value detected from at least one of the first or second switches is equal to or greater than the reference current value, the electronic apparatus may transmit an error signal to a user terminal apparatus that performs communication with the electronic apparatus (S740).

Meanwhile, according to an embodiment, the above-described various embodiments may be implemented as software including instructions stored in machine-readable storage media, which can be read by machine (e.g.: computer). The machine refers to a device that calls instructions stored in a storage medium, and can operate according to the called instructions, and may include a wireless transmission apparatus according to the aforementioned embodiments. In case an instruction is executed by a processor, the processor may perform a function corresponding to the instruction by itself, or by using other components under its control. The instruction may include a code that is generated or executed by a compiler or an interpreter. The machine-readable storage medium may be provided in the form of a non-transitory storage medium. Here, the term 'non-transitory' means that the storage medium is tangible without including a signal, and does not distinguish whether data are semi-permanently or temporarily stored in the storage medium.

In addition, according to an embodiment, the above-described methods according to the various embodiments may be included and provided in a computer program product. The computer program product may be traded as a product between a seller and a purchaser. The computer program product may be distributed in a form of a storage medium (e.g., a compact disc read only memory (CD-ROM)) that may be read by the machine or online through an application store (e.g., PlayStore^{™}). In case of the online distribution, at least a portion of the computer program product may be at least temporarily stored in a storage medium such as a memory of a server of a manufacturer, a server of an application store, or a relay server or be temporarily generated.

In addition, the components (for example, modules or programs) according to various embodiments described above may include a single entity or a plurality of entities, and some of the corresponding sub-components described above may be omitted or other sub-components may be further included in the various embodiments. Alternatively or additionally, some components (e.g., modules or programs) may be integrated into one entity and perform the same or similar functions performed by each corresponding component prior to integration. Operations performed by the modules, the programs, or the other components according to the diverse embodiments may be executed in a sequential manner, a parallel manner, an iterative manner, or a heuristic manner, or at least some of the operations may be performed in a different order or be omitted, or other operations may be added.

Although preferred embodiments of the present disclosure have been shown and described above, the disclosure is not limited to the specific embodiments described above, and various modifications may be made by one of ordinary skill in the art without departing from the gist of the disclosure as claimed in the claims, and such modifications are not to be understood in isolation from the technical ideas or prospect of the disclosure.

## Claims

1. An electronic apparatus comprising:
an inverter including a plurality of switch pairs each including first and second switches connected in series;
a three-phase motor respectively connected to connection nodes between the first and second switches in the plurality of switch pairs; and
a processor configured to control the inverter to convert direct current (DC) power into three-phase alternating current (AC) power and provide the three-phase alternating current power to the three-phase motor,
wherein the processor is configured to:
control each first switch included in the plurality of switch pairs to be in an on state for a preset first time, and identify whether each second switch included in the plurality of switch pairs is abnormal based on a magnitude of a current detected in the inverter during the first time; and
control each second switch included in the plurality of switch pairs to be in the on state for a preset second time, and identify whether each first switch is abnormal based on a magnitude of a current detected in the inverter during the second time.

2. The electronic apparatus of claim 1, wherein the inverter includes:
an Intelligent Power Module (IPM) configured to convert the direct current power into the three-phase alternating current power based on a Pulse Width Modulation (PWM) signal; and
at least one sensor connected to the first switch or the second switch to detect current,
wherein the IPM includes three first switches connected to a negative node of the direct current power and three second switches connected to a positive node of the direct current power, and the first switches and the second switches are implemented as Insulated Gate Bipolar Transistors (IGBTs).

3. The electronic apparatus of claim 1, wherein the processor is configured to:
set the first time as a bootstrap time of the three-phase motor, control each first switch included in the plurality of switch pairs to be in an on state during the first time in which bootstrapping of the three-phase motor is performed, and identify whether each second switch included in the plurality of switch pairs is abnormal based on a magnitude of a current detected in the inverter during the first time.

4. The electronic apparatus of claim 1, wherein the processor is configured to:
before starting the three-phase motor, control each second switch included in the plurality of switch pairs to be in an on state for the preset second time, and identify whether each first switch is abnormal based on a magnitude of a current detected in the inverter during the second time.

5. The electronic apparatus of claim 1, further comprising:
memory storing data regarding the first time and the second time,
wherein the first time and the second time are respectively set as times equal to or greater than a minimum pulse width capable of detecting a short current in the inverter and stored in the memory.

6. The electronic apparatus of claim 1, wherein the processor is configured to:
based on a current value detected in at least one of the first switch or the second switch being equal to or greater than a preset reference current value, control the first and second switches to be in an off state so as to stop operation of the three-phase motor.

7. The electronic apparatus of claim 1, further comprising:
a display,
wherein the processor is configured to:
based on a current value detected in at least one of the first switch or the second switch being equal to or greater than a preset reference current value, control the display to display a fault state.

8. The electronic apparatus of claim 1, further comprising:
a communicator configured to perform communication with a user terminal apparatus,
wherein the processor is configured to:
based on a current value detected in at least one of the first switch or the second switch being equal to or greater than a preset reference current value, control the communicator to transmit an error signal to a preset user terminal apparatus.

9. A method of controlling an electronic apparatus including n inverter including a plurality of switch pairs each including first and second switches connected in series and a three-phase motor, the method comprising:
turning on each first switch included in the plurality of switch pairs for a preset first time;
identifying whether each second switch included in the plurality of switch pairs is abnormal based on a magnitude of a current detected in the inverter during the first time;
turning on each second switch included in the plurality of switch pairs for a preset second time; and
identifying whether each first switch is abnormal based on a magnitude of a current detected in the inverter during the second time.

10. The method of claim 9, further comprising:
setting and storing the first time as a bootstrap time of the three-phase motor.

11. The method of claim 9, further comprising:
setting and storing the first time and the second time respectively as times equal to or greater than a minimum pulse width capable of detecting a short current in the inverter.

12. The method of claim 9, further comprising:
based on a current value detected in at least one of the first switch or the second switch being equal to or greater than a preset reference current value, turning off the first and second switches so as to stop operation of the three-phase motor.

13. The method of claim 12, further comprising:
based on a current value detected in at least one of the first switch or the second switch being equal to or greater than a preset reference current value, displaying a fault state of the electronic apparatus.

14. The method of claim 12, further comprising:
based on a current value detected in at least one of the first switch or the second switch being equal to or greater than a preset reference current value, transmitting an error signal to a user terminal apparatus configured to perform communication with the electronic apparatus.

15. A computer-readable recording medium including a program for executing a method of controlling an electronic apparatus that includes an inverter including a plurality of switch pairs each including first and second switches connected in series and a three-phase motor, the method comprising:
turning on each first switch included in the plurality of switch pairs for a preset first time, and identifying whether each second switch included in the plurality of switch pairs is abnormal based on a magnitude of a current detected in the inverter during the first time; and
turning on each second switch included in the plurality of switch pairs for a preset second time, and identifying whether each first switch is abnormal based on a magnitude of a current detected in the inverter during the second time.
